# EUROPÄISCHE PATENTSCHRIFT

(11) **EP 1 510 112 B1**
(45) Veröffentlichungstag und Bekanntmachung des Hinweises auf die Patenterteilung: **21.12.2005**
(21) Anmeldenummer: 03724979.4
(22) Anmeldetag: 09.04.2003
(51) Int. Cl.: H05K 5/06, G02B 7/00, H01S 5/022

(54) **VERFAHREN ZUR HERMETISCHEN BEHÄUSUNG VON OPTISCHEN BAUELEMENTEN SOWIE VERFAHRENSGEMÄSS HERGESTELLTE OPTISCHE BAUELEMENTE**
METHOD FOR HERMETICALLY HOUSING OPTICAL COMPONENTS, AND OPTICAL COMPONENTS PRODUCED ACCORDING TO SAID METHOD
PROCEDE POUR ENROBER DE FACON HERMETIQUE DES COMPOSANTS OPTIQUES ET COMPOSANTS OPTIQUES REALISES CONFORMEMENT A L'INVENTION

(30) Priorität: 03.06.2002 DE 10224710
(43) Veröffentlichungstag der Anmeldung: 02.03.2005
(73) Patentinhaber: Schott AG, 55122 Mainz (DE)
(72) Erfinder: MUND, Dietrich, 84101 Obersüssbach (DE); HAMMER, Bernd, 84036 Landshut (DE); HETTLER, Robert, 84036 Kumhausen (DE); SCHACHTLBAUER, Klaus, 84036 Kumhausen (DE); SAUSENTHALER, Edeltraud, 84030 Ergolding (DE); MAYER, Markus, 84032 Landshut (DE)
(74) Vertreter: Herden, Andreas F.
(86) Internationale Anmeldenummer: PCT/EP2003/003649
(87) Internationale Veröffentlichungsnummer: WO 2003/103358

(56) Entgegenhaltungen:
- DE-A- 3 729 411
- DE-A- 3 830 149
- US-A- 5 878 069

## Beschreibung

Die Erfindung betrifft ein Verfahren zur hermetischen Behäusung von optischen Bauelementen, insbesondere zur Herstellung eines Gehäusekörpers oder von Teilen davon, bei welchem eine hermetische Verkapselung von vorzugsweise optoelektronischen Bauteilen erfolgt, und betrifft ferner verfahrensgemäß hergestellte optische Bauelemente.

Hermetisch ge- oder verkapselte Gehäuse dienen häufig dazu, empfindliche Bauteile wie Laser oder Photodioden vor Umwelteinflüssen zu schützen und helfen dabei, eine ausreichende Lebensdauer dieser Bauteile sicherzustellen.

Zur Herstellung derartiger Gehäuse/Optokappen wurden bisher dem Fachmann an sich bekannte Glas-Metall-Verbindungs-Technologien eingesetzt, bei welcher das Gehäuse aus einer Metall- und einer als Fenster dienende Glaskomponente besteht, die miteinander hermetisch verbunden wurden.

Die US-A-5 878 069 zeigt ein Verfahren gemäß dem Oberbegriff von Auspruch 1.

Gehäuse dieser Art bestehen häufig aus einem hülsenförmigen Metallkörper und einer in der Hülse aufnehmbaren und als Fenster dienenden Glasscheibe. Bei der bekannten Herstellung derartiger Gehäuse/Optokappen erfolgte das Verbinden von Metall- und Glaskomponente mittels eines ringförmig angeordneten Glaslotes, welches als gesintertes Formteil eingesetzt wurde ; vgl. DE-A-37 29 411). Hierbei musste zunächst vor dem eigentlichen Zusammenfügen der Komponenten das Glaslot-Formteil in einem separaten Arbeitsgang in Sintertechnologie hergestellt werden. Anschließend wurde das Formteil passgenau in die hülsenförmige Metallkomponente eingelegt und mit der runden Glasscheibe abgedeckt. Es folgt dann der Einschmelzvorgang, bei dem Hülse und Glasscheibe hermetisch und kraftschlüssig miteinander verbunden werden. Um die gewünschte Hermizität des Gehäuses sicherzustellen, musste jeweils die Lage und Form des Glaslotes zwischen Metallhülse und Glasscheibe gut angepasst werden. Dazu sind enge Toleranzen sowohl bei den Gehäuse-Komponenten als auch beim Glaslot zu beachten. Beim Herstellen und Einsetzen der Glaslot-Formteile ist daher große Aufmerksamkeit erforderlich, was zeitaufwendig und kostspielig ist. Häufig, insbesondere bei schräg angeordneten Fügeflächen waren dennoch hohe Ausschußqouten nicht zu vermeiden, da ein Verlaufen der Glaslot-Formteile zu einem zu ungenauen Auftrag führte.

Darüber hinaus stößt diese Technik an deutliche Machbarkeitsgrenzen, sobald das Glasfenster nicht mehr in Form als Rundscheibe sondern mit einer eckigen Kontur, insbesondere als Rechteck oder in anderen, von einer einfachen runden Geometrie abweichenden Formen benötigt wird oder die mit Glaslot zu belegende Fläche nicht waagrecht oder gewölbt geformt ist. Die entsprechenden Glaslot-Formteile in Sintertechnologie herzustellen ist von deren Form her nur sehr begrenzt und nicht mit der erforderlichen Genauigkeit möglich.

Auch für Optokappen, deren Fenster schräg in der metallischen Hülse angeordnet sind, ist das herkömmliche Verfahren wegen zu großer Lotmenge und dem verrutschen des Lotringes vor dem Einschmelzen oder während des Lötvorgangs ungeeignet.

Der Erfindung liegt die Aufgabe zugrunde, ein präzises und für verschiedene Gehäusegeometrien einsetzbares Verfahren der im Oberbegriff des Anspruches 1 genannten Art zu entwickeln, welches eine zuverlässige und kostengünstige, vorzugsweise hermetische, Verbindung zwischen Metallhülse und Glasscheibe ermöglicht.

Diese Aufgabe wird mit einem Verfahren mit den Merkmalen des Anspruchs 1 sowie durch einen Gehäusekörper mit den Merkmalen des Anspruchs 19 gelöst.

Wenn vor dem Zusammenfügen von Gehäuseelement und Gehäuseanordnung das Glaslot als formbare Masse, insbesondere als Paste, aufgetragen wird und durch zumindest einen einmaligen Energieeintrag, insbesondere durch Ausbrennen organischer Bestandteile, das Glaslot vorverglast und in seiner Form fixiert wird hat dies große Vorteile, da nahezu jegliche Form, sowohl zweidimensionale ebene als auch gewölbte Formen mit Glaslot örtlich exakt definiert versehen werden können. Nach Einsetzen des Gehäuseelements in die Gehäuseanordnung kann dann durch Erwärmen eine zumindest bereichsweise hermetische Verbindung zwischen Gehäuseelement und Gehäuseanordnung hergestellt werden.

Bei einer besonders bevorzugten Ausführungsform umfasst das Gehäuseelement ein Fenster, welches aus einer Glasscheibe besteht, und die Gehäuseanordnung eine Gehäusekappe.

Das Auftragen der Glaslotpaste kann vorteilhaft zumindest bereichsweise auf der Glasscheibe und/oder der Gehäusekappe erfolgen, wobei durch einen Mehrfachauftrag die Höhe des aufgebrachten Glaslotes und auch dessen Menge exakt einstellbar ist.

Wenn das Auftragen der Glaslotpaste in die Gehäusekappe auf einer im Umfangsbereich angeordneten Auflagefläche erfolgt, kann bei geschlossener Anordnung des Glaslotes eine vollständige hermetische Verbindung erzeugt werden.

Hilfreich ist es, insbesondere bei größeren Mengen von Glaslot, wenn das Auftragen der Glaslotpaste auf die Auflagefläche in der Gehäusekappe in einem durch eine Sicke von der übrigen Auflagefläche abgegrenzten Lotbereich erfolgt.

In überraschender Weise kann die Glaslotpaste auf eine Antireflex- oder Antikratzschicht aufgetragen werden, welche an der Oberfläche des Gehäuseelements, insbesondere des Fensters angeordnet ist und können hierdurch hochwertige optische Elemente, wie beispielsweise Linsen, Kugellinsen, Zylinderlinsen oder auch optische Filter wie DWDM-Filter oder Gitter montiert werden.

Vorteilhaft ist es, wenn die Formgebung der Glaslotpaste, insbesondere der Querschnitt oder die Dicke einer aufgetragenen Strecke durch Einstellung der Pastenrheologie beeinflußt und/oder eingestellt wird, denn hierbei kann die Viskosität der Glaslotpaste an die jeweiligen Montagebedingung angepasst werden, wobei bei niedrigeren Viskositäten dünnere Lotschnüre und bei höheren Viskositäten dickere Lotschnüre erzeugbar sind. Ferner kann das Verlaufen der aufgetragenen Lotschnur durch deren Viskosität beeinflusst bzw. an den Montageprozess angepasst werden.

Wenn die Glaslotpaste mittels einer Dosiervorrichtung, insbesondere eines Dispensers und vorzugsweise mittels eines Nadeldispensers, dosiert aufgetragen wird lassen sich auch schräg oder auf komplexe Weise im Raum verlaufende Flächen zuverlässig und in exakt vordefinierter Weise mit Glaslot versehen. Hierdurch können beispielsweise auch zylindrische Flächen von Gehäusen oder Zylinderlinsen, beispielsweise bei in x- und/oder y-Richtung scannenden optischen Erfassungs- oder Schreibsystemen miteinander verbunden werden.
Äußerst vorteilhaft ist es, wenn die Dosiervorrichtung ein mit einer Düse versehener Ring- oder Rechteckdispenser ist, denn dann kann bei entsprechender Auftragsgeometrie ein einziger, dosierter und vorzugsweise zeit/druckgesteuerter Auftrag ausreichen, um die benötigte Glaslotmenge vollständig aufzubringen.

Alternativ oder zusätzlich kann auch durch Wahl der Dispensernadel oder der Abmessungen der Düse die Lotschnurdicke des pastenförmig aufgebrachten Glaslots vorteilhaft beinflusst und/oder eingestellt wird.

Größere Flächen können vorteilhaft ebenfalls in einmaligen Auftragsvorgang mit Glaslot beschichtet werden, wenn die Glaslotpaste mittels Schablonendruck, insbesondere mittels Siebdrucktechnik die Glasscheibe aufgetragen wird.

Bei einer Vielzahl gleicher oder ähnlicher Elemente kann die Fertigung kostengünstig gestaltet werden, indem zunächst auf einer Mutterscheibe, welche eine Vielzahl von Einzelscheiben definiert oder umfasst, ein Glaslot vordefinierter Flächengeometrie aufgebracht wird, durch einen Energieeintrag, insbesondere durch Ausbrennen organischer Bestandteile das Glaslot vorverglast und in seiner Form fixiert wird, Scheiben aus der Mutterscheibe vereinzelt werden und die vereinzelte Scheibe mit vorverglastem Glaslot in die Gehäusekappe eingesetzt und durch thermische Einwirkung eine hermetische Verbindung zwischen Glasscheibe und Gehäusekappe hergestellt wird.

Vorteilhaft wird die Scheibe aus der Mutterglasscheibe durch Ritzen und Brechen oder mittels Laserschneiden vereinzelt.

Um bei Geometrien, welche einfache und komplexere Strukturen umfassen alle Vorteile, insbesondere auch die Vorteile herkömmlicher Verfahren nutzen zu können kann auch ein Sinterglas-Formkörper und pasteuses Glaslot auf den Gehäusekörper und/oder das Gehäuseelement aufgebracht werden, um derart größere Mengen an Glaslot mittels des Sinterglas-Formkörpers und komplexe Strukturen mittels des pasteusen Glaslots aufzutragen.

Ferner stellen bereits Gehäusekörper mit einem Abschnitt eines vorverglasten Glaslots eigenständig handelbare Güter dar, da dann ein Abnehmer dessen eigene Gehäuseelemente, wie beispielsweise Fenster, Linsen oder Filter in den Gehäusekörper einlegen und durch Erwärmung oder Energieeintrag in diesem hermetisch befestigen kann.

Ein besonders bevorzugter Gehäusekörper umfasst eine metallische, hülsenförmigen Kappe, ein Gehäuseelement, welches vorzugsweise eine als Fenster dienende Glasscheibe aufweist, sowie ein zwischen Fenster und Metallkappe angeordnetes Glaslot.

Nachfolgend wird die Erfindung anhand bevorzugter Ausführungsformen und unter Bezugnahme auf die beigeschlossenen Zeichnungen detaillierter beschrieben.
Es zeigen:
- Fig. 1: Teile eines Gehäusekörpers, welcher die Optokappe eines optoelektronischen Bauteils umfaßt, im vorliegenden Falle eines Halbleiterlasers, in einer Querschnittdarstellung in der Ebene der Längsachse X der Optokappe,
- Fig. 2: einen Blick in die in Figur 1 dargestellte Optokappe in Richtung des Pfeiles Y aus Fig. 1,
- Fig. 3: ein Detail einer Querschnittsansicht einer rechteckförmigen Optokappe, welche in deren Gesamtheit im Querschnitt in Fig. 4 dargestellt ist,
- Fig. 4: eine Querschnittsansicht durch eine rechteckförmige Optokappe mit Angabe der Lage der Detaildarstellung gemäß Fig. 3,
- Fig. 5: eine Aufsicht auf die in den Fig. 3 und 4 dargestellte rechteckförmige Optokappe,
- Fig. 6: eine Aufsicht auf eine weitere Ausführungsform einer rechteckförmigen Optokappe,
- Fig. 7: eine Querschnittsdarstellung der rechteckförmigen Optokappe aus Fig. 6 entlang in der in Fig. 6 dargestellten Eben BB,
- Fig. 8: ein Detail der Fig. 7, welches in Fig. 7 mit V bezeichnet ist,
- Fig. 9: ein Detail der Fig. 6, welches in Fig. 6 mit W bezeichnet ist,
- Fig. 10: eine weiter Ausführungsform einer Optokappe in einer teilweisen Querschnittdarstellung in einer Ebene, welche die Längsachse X- dieser Optokappe umfaßt,
- Fig. 11: eine Mutterscheibe mit einer Vielzahl von Fenstern welche jeweils zu eigenständig montagefähigen Einzelfenstern vereinzelbar sind,
- Fig. 12: eine Detaildarstellung der in Fig. 11 dargestellten Mutterscheibe nach dem Aufbringen von Glaslot,
- Fig. 13: eine Querschnittsdarstellung durch die Detailansicht der Fig. 12 entlang der Ebene CC,
- Fig. 14: eine Querschnittsdarstellung durch eine Optokappe und einem Dispenser mit einer ring- oder rechteckförmigen Düse vor und nach dem Auftragen der Glaslotpaste.

### Detaillierte Beschreibung bevorzugter Ausführungsformen

Im Allgemeinen nutzt die Erfindung als Verbindung zwischen beispielsweise einer Metallhülse, die einen Gehäusekörper bildet und etwa einer Glasscheibe, welche ein Gehäuselement bildet, ein als formbare Masse auftragbares Glaslot, vorzugsweise eine Glaslotpaste. Mit dem als Paste ausgebildeten Glaslot ist es möglich, die Form des Glaslotes sehr genau an die Geometrie der jeweiligen Einzelteile angepaßt festzulegen.

Auf diese Weise ist es möglich, nahezu jede beliebige Form des Glaslotes zu realisieren und selbst komplizierte Flächengeometrien können durch geeignete Wahl der jeweiligen Auftragungstechnik in sehr präziser Form zuverlässig verwirklicht werden.

Da die Paste nach dem Auftragen in deren Form noch veränderlich ist, kann diese etwaige noch vorhandene Massungenauigkeiten ausgleichen. Metallhülse und Fenster können folglich mit einer höheren Paßgenauigkeit zusammengefügt werden, als diese von den einzelnen Komponenten bereitgestellt werden.

Erst bei einem nachfolgenden Temperaturprozess, beispielsweise nach Ausbrennen der organischen Bestandteile wird die Glaslotpaste in ihrer Lage und Form fixiert. Ein zusätzlicher Arbeitsgang zum Herstellen eines separaten Glaslot-Formteiles ist generell nicht mehr notwendig. Vorteilhafterweise lassen sich mit diesem Verfahren auch Optokappen realisieren, in denen das Glasfenster schräg eingebaut wird.

Aufgrund der Adhäsionskraft der Paste bleibt die Form der Paste nach Auftragen entweder auf der Glasscheibe oder vorzugsweise auf der Metallhülse erhalten. Ein ungewolltes Verrutschen der Lotschnur vor dem Einschmelzvorgang ist nicht mehr zu erwarten, da die jeweilige örtliche Menge des aufgebrachten Glaslotes sehr genau dosierbar ist und nicht durch die Formgebung von Sinterglaslotteilen, etwa durch deren minimal nötige Dicke beeinträchtigt wird.

Nachfolgend werden spezielle und bevorzugte Ausführungsformen der Erfindung anhand verschiedener Gehäusekörper und Gehäuseelemente, wie Standard-Optokappen für TO52, TO05 Sockel oder auch schräge Optokappen für TO52 Sockel beschrieben.

Bei der nachfolgenden Beschreibung werden gleiche Bezugszeichen für gleiche oder ähnliche Baugruppen der jeweiligen, voneinander verschiedenen Ausführungsformen benutzt. Ferner sind die Darstellungen in den verschiedenen Figuren nicht zwingend maßstabsgerecht, um die Klarheit und Erkennbarkeit des Wesens der Erfindung nicht zu beeinträchtigen.

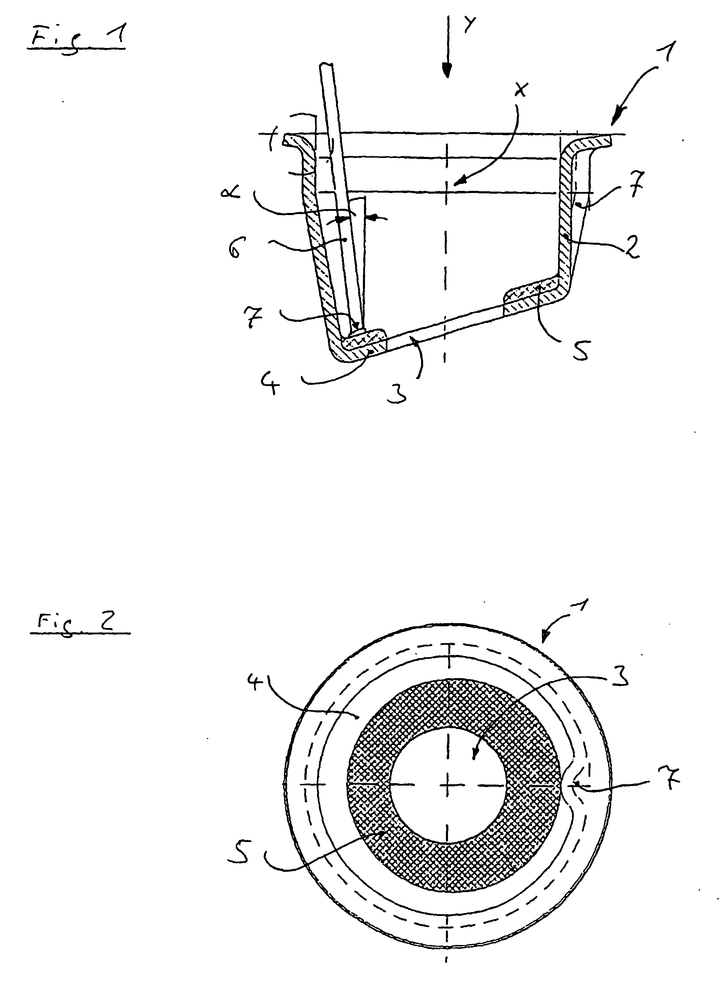

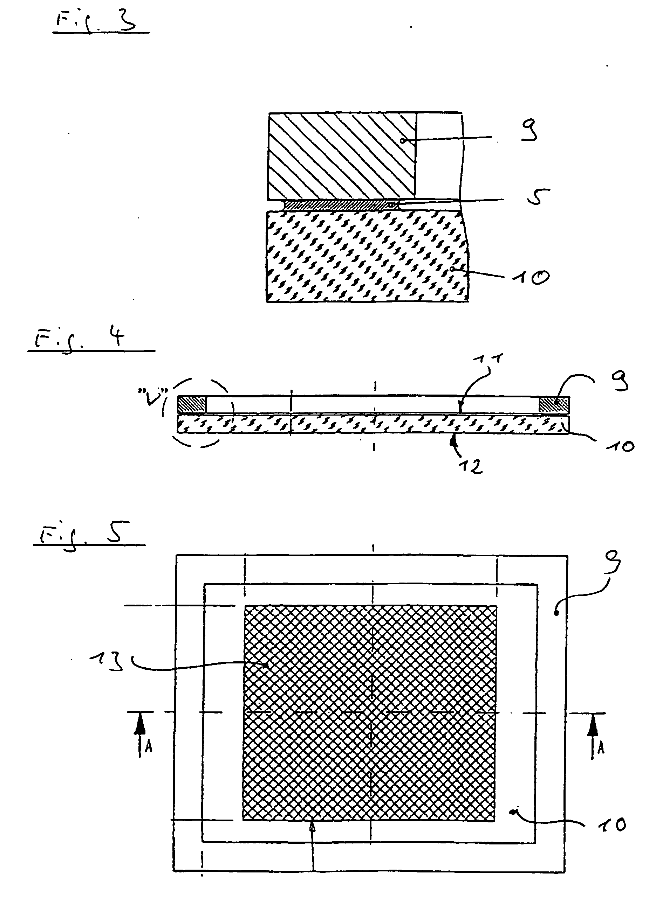

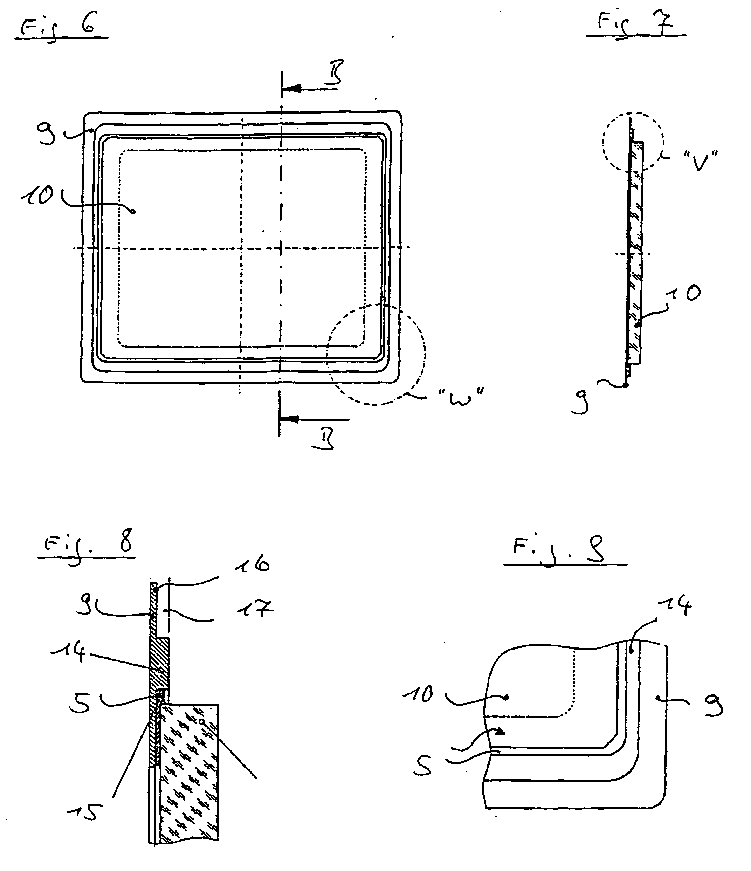

In Fig. 1 ist eine, insgesamt mit 1 bezeichnete Optokappe während des Fertigungsvorgangs dargestellt. Diese Optokappe 1 umfaßt eine zylindrische oder kegelstumpfförmige Metallhülse 2 mit einer Durchgangsöffnung 3 in deren Bodenfläche 4.

Die Durchgangsöffnung 3 ist geeignet, um beispielsweise das Licht eines Laserstrahl oder durch optische Elemente wie beispielsweise Linsen oder Filter beeinflußt hindurch treten zu lassen.

Auf der Innenseite der Bodenfläche 4 wird erfindungsgemäß eine pastöse Glaslotschicht 5, welche im vorliegenden Beispiel die Öffnung 3 vollständig umgibt als Lötschnur mit einem Nadeldispenser aufgetragen.

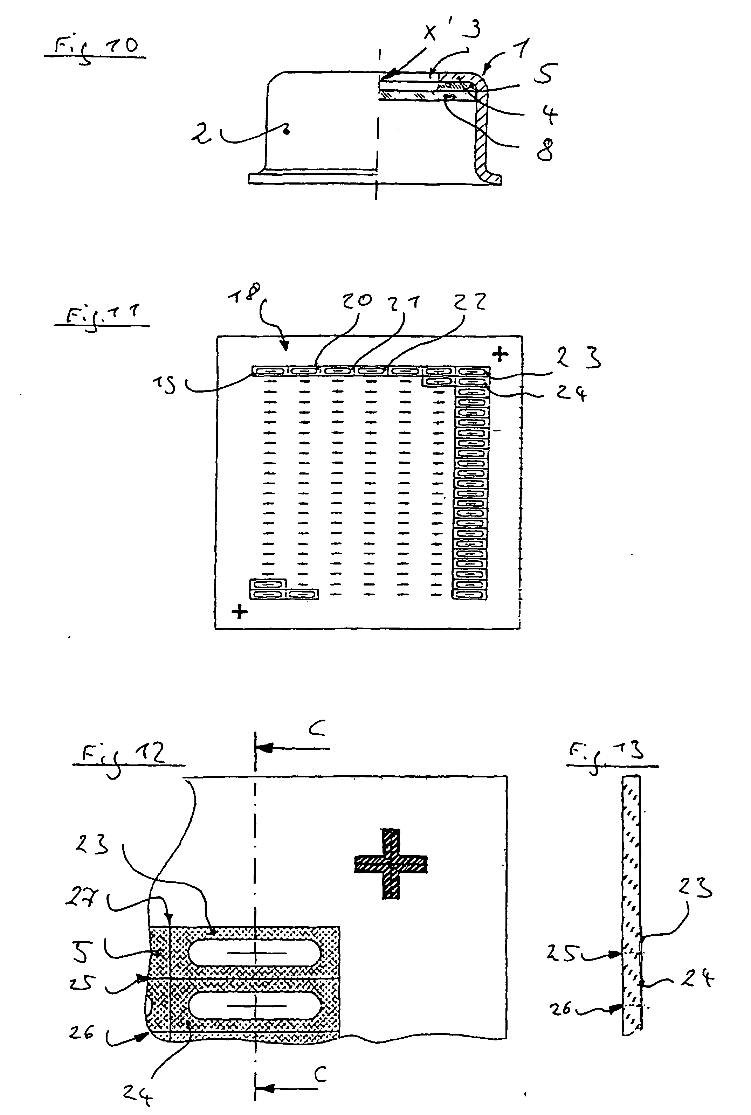

Der hierdurch gebildete vollständig geschlossene Kreis ist besser in Fig. 2 zu erkennen, welche einen Blick in die in Figur 1 dargestellte Optokappe in Richtung des Pfeiles Y aus Fig. 1 zeigt. Wie aus Figur 1 erkennbar, taucht die Nadel 6 eines Nadeldispensers in das Innere der Metallhülse 3 ein und trägt an deren unterseitigem Ende 7 die pastöse Glaslotschicht 5 auf. Derartige Nadeldispenser werden beispielsweise von der Fa. Sieghard Schiller GmbH & Co. Kg., Sonnenbuehl, Deutschland, unter der Bezeichnung Inline Dispenser vertrieben.

Hiermit sind seitliche Toleranzen der aufgetragenen Glaslotschicht von +/- 10 µm erreichbar und können innerhalb dieser Toleranzen erneute Nadelzustellungen vorgenommen werden, wobei auch Mehrfachbeschichtungen neben oder übereinander mit dieser Genauigkeit durchführbar sind.

Erhöhte Genauigkeiten werden mit Piezotranslatorischen Zustellsystemen verwirklicht, welche nötigenfalls auch interferometrisch in deren Ver- oder Zusstellbewegung kontrollierbar sind. Hiermit werden Genauigkeiten im Bereich von weniger als 1 µm erreicht. Bevorzugte Dicken der aufgetragenen Glaslotpaste beginnen ab etwa 500 µm Lötschnurdicke, die etwa der Breite einer aufgetragenen Strichstärke entsprechen und sind in deren Breite erfindungsgemäß nicht beschränkt.

Der Vorgang des Auftragens umfaßt eine Steuerung oder Einstellung der Verfahrgeschwindigkeit der Dispensernadel zumindest während des Auftragens der Glaslotpaste, des Druckes, mit welchem die Glaslotpaste austritt und der Zeit, wie lange die Glaslotpaste austritt, so daß hiermit die Schichtdicke eines jweiligen Einmalauftrags einstellbar wird.

Bei dem in Fig. 1 dargestellten Auftragsvorgang weist die Nadel 6 eine Verkippung um einen Winkel α von etwa 30 Grad +/- 3 Grad relativ zur Längsachse X der Optokappe 1 auf und wird entlang einer schräg zur Achse X liegenden Ellipse parallel zur unteren Bodenfläche 4 verfahren. Auch die Neigung der Bodenfläche 4 beträgt etwa 30 Grad relativ zur Längsachse X.

Alternativ kann die Nadel 6 parallel zur Längsachse Y der in Fig. Dargestellten Optokappe geführt werden.

Zum Erreichen dickerer oder abgestuft in der Dicke zunehmender Schichten lassen sich bereichsweise oder vollumfängliche Mehrfachaufträge vornehmen.

Nach Aufbringen des Glaslotes wird die Metallhülse 2 zusammen mit der Glaslotschicht 5 erhitzt wodurch die pastöse Glaslotschicht 5 verglast und nachfolgend in deren Lage fixiert wird. Hierbei werden organische Bestandteile des pastösen Glaslots entfernt.

Nach diesem Verfahrensschritt ist eine eigenständig handelbare Metallhülse entstanden, in welche beispielsweise von einem Endverbraucher weitere Elemente einbringbar sind und durch Erwärmung in deren relativer Lage zur Metallhülse 2 fixierbar sind.

Generell können als Glaslot beispielsweise alle von der Fa. Schott Glas vertriebenen Glaslote verwendet werden, beispielsweise die Glaslote mit der Bezeichnung 8465, 8467, 8468, 8470, 8471, 8472, 8474 sowie Komposit-Glaslote mit der Nummer G017-002, G017-344, G017-339, G017-340, G017-383, G017-393, G017-334 sowie kristallisierende Glaslote, wie beispielsweise die Glaslote 8587, 8593, 8596, 8597 und können als Gehäuseelemente vorzugsweise Glasfenster eingelötet werden, die jeweils eine höhere Temperaturfestigkeit aufweisen, dies bedeutet eine höhere Temperatur Tg als die entsprechende Löttemperatur des verwendeten Glaslots aufweisen.

Ein bevorzugte Gläser sind Spezielgläsermit der Bezeichnung D263, AF37, AF45, B270, Borofloat™33 und Borofloat40 der Fa. Schott Glas, Mainz.

Die hülsenförmigen Gehäusekappe besteht vorzugsweise aus einer metallischen Legierung, die gewisse Mengen an Nickel enthält, wie beispielsweise die Legierung mit der Bezeichnung NiFe47.

Mehrere, der Einfachheit wegen in den Figuren nicht dargestellte Optokappen können parallel mit Mehrnadeldispensern beschichtet werden. Dabei werden in deren Lage gleich ausgerichtete Metallhülsen in Mehrfachträgern angeordnet und mit Mehrnadelsystemen in einem einzigen Arbeitsgang beschichtet.

Eine Einsenkung 7 in der Metallhülse 3 bewirkt im Zusammenwirken mit einer entsprechend geformten Nase in einem Träger, dass eine winkelgenaue Positionierung aller Optokappen gleichzeitig möglich wird. Auf derartigen Trägern können einige hundert Optokappen gehaltert sein und mit Mehrnadeldispensern stepperartig mit Glaslotpaste versehen werden.

Nach dem Verglasen des Glaslotes kann ein Gehäuseelement, wie beispielsweise eine Glasscheibe 8, die Fig. 10 in deren montiertem Zustand gezeigt ist, in die Hülse 2 eingelegt werden. Die Glasscheibe 8 besteht aus einem der vorstehend erwähnten Gläser der Fa. Schott Glas, Mainz.

Nach dem Einlegen kann die Anordnung aus Metallhülse 2 und Glasscheibe 8 erwärmt werden, wodurch die Glaslotschicht 5 erweicht und nachfolgend eine hermetische Lötverbindung zwischen der Scheibe 8 und der Hülse 2 herstellt. Die Glasscheibe 8 besteht aus dem vorstehend erwähnten Glas mit der Bezeichnung D263 der Fa. Schott Glas, Mainz

Das Dispensen des Glaslotes mit einer Mehrnadelsystem, erfolgt vorzugsweise mit einem Dispenserkopf mit 2, 4 oder 8 Nadeln, welches die Produktivität des Auftragens um die Anzahl der Nadeln multipliziert.

Die Offset- oder Versatzkontrolle der Dispensernadeln untereinander kann durch eine Nadelkontrollstation erfolgen. Die daraus resultierende Nadelpositionskorrektur wird durch voneinander unabhängige Verstellachsen realisiert, wobei jede Nadel mit einem eigenen unabhängigen Achsensystem ausgerüstet ist.

Bei einer weniger bevorzugten Ausführungsform kann der Vorgang des Vorverglasens zusammen mit dem Vorgang des Einlötens innerhalb eines einzigen Erwämungsschrittes durchgeführt werden, welcher eine entsprechende längere Dauer hat, um das Ausbrennen organischer Bestandteile zu ermöglichen. Eine nachfolgende Reinigung der dabei entstandenen Baugruppe kann, obwohl in der Regel nicht notwendig, Rückstände der organischen Bestandteile entfernen.

Ferner können an Stelle von runden Durchgangsöffnungen 3 sowie Glasscheiben 8 auch rechteckförmige, elliptische, ovale, mehreckige oder je nach Einsatzfall spezifisch geformte Öffnungen 3 und Glasscheiben 8 oder optische Elemente 8 an den Gehäuseelementen 2 befestigt werden.

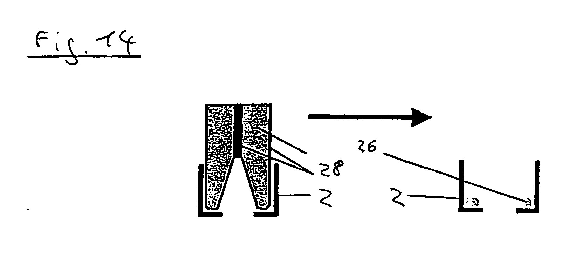

In Fig. 3 ist ein rechteckförmiger metallischer Träger 9 dargestellt, an welchem eine Glasscheibe 10 mittels einer Glaslotschicht 5 befestigt ist.

Die Erfindung unterscheidet sich von herkömmlichen Verfahren, bei welchen zur Befestigung von derartigen rechteckförmigen Glasscheiben an metallischen Trägern bisher Metallschichten auf dem Glas aufgebracht werden mußten, welche nachfolgen mit einem Metallot auf den Träger 9 gelötet wurden. Bei dem erfindungsgemäßen Verfahren bedarf es nicht mehr einer derartigen Metallbedampfung, wodurch diese Form der Befestigung sehr kostensparend und zeitlich effektiv ist.

Dennoch kann, beispielsweise bei Gehäusen optischer CCD-Sensoren die Glasscheibe 10 eine Antireflexschicht 11, 12 an einer oder beiden von deren Hauptoberflächen aufweisen.

Auch Antikratzschichten, ebenfalls in Verbindung mit Antireflexschichten können an der Glasscheibe 10 angebracht sein. Aus Fig. 5, welche eine Aufsicht auf die in den Fig. 3 und 4 dargestellte rechteckförmige Optokappe zeigt, ist zu erkennen, daß die Glasscheibe 10 bei fertiggestelltem Gehäuse beispielsweise vor einem CCD-Array 13 angeordnet sein kann.

An Stelle des CCD-Arrays 13 können auch mikromechanisch verstellbare Spiegelsysteme, beispielsweise von TV- und Video-Projektionseinrichtungen oder andere Elemente mit einem rechteckförmigen Ein- oder Austrittsfenster verkapselt werden.

Fig. 6 zeigt eine weitere Ausführungsform einer erfindungsgemäßen Gehäuseanordnung, bei welcher die Glasscheibe 10 jedoch nicht die gleichen Seitenabmessungen wie der metallische Träger 9 aufweist.

Der metallische Träger 9 weist bei dieser Ausführungsform einen Steg 14 auf, welcher eine Sicke 15 definiert, in der die Glaslotschicht 5 auf einer durch den Träger 9 definierten Auflage angeordnet wird. Durch den Steg 14 sowie die Sicke 15 wird das Glaslot seitlich begrenzt und kann auch weicheres, stärker fließfähiges Glaslot mit niedrigerer Viskosität Verwendung finden.

Bei der in den Fig. Von 6 bis 9 dargestellten Ausführungsform kann ein metallischer Randbereich 16 der weiteren Halterung, beispielsweise an einer externen Baugruppe 17 dienen. Der Randbereich 16 kann beispielsweise für die Anlage einer Dichtung bei wiederverschließbaren Gehäusen oder Fenstern Verwendung finden oder kann durch weitere Befestigungstechniken wie beispielsweise Kleben oder Löten an externen Gehäusen angebracht werden. Der metallische Träger kann somit Teil einer komplexer geformten Gehäusestruktur, insbesondere einer größeren Gehäusekappe sein.

An Stelle des Auftrags auf einen metallischen Träger oder eine Metallhülse kann der Auftrag der Glaslotschicht 5 auch auf ein Glas, wie beispielsweise in den Fig. 11 bis 13 dargestellt erfolgen.

Ferner kann ohne Beschränkung der Allgemeinheit auch Glaslot sowohl auf die metallische Hülse 2 oder den Träger 9 und auf eine Glasscheibe beziehungsweise ein weiteres Gehäuseelement aufgebracht werden.

Auch herkömmliche Sinterformteile lassen sich zusammen mit dem pastösen Glaslot verwenden, wobei beispielsweise komplexere Formen an ein Sinterformteil angrenzend mit einem Nadeldispenser aufgebracht oder mit den nachfolgend beschriebenen Techniken aufgedruckt werden.

Fig. 11 zeigt eine Mutterplatte 18, an welcher eine Vielzahl, vorzugsweise identisch geformter Fensterflächen 19 bis 24 durch das Aufbringen der Glaslotschicht 5 definiert wird.

Die Glaslotschicht 5 kann zwar mit Mehrnadeldispensern auch bei dieser Ausführungsform aufgebracht werden, jedoch wird hierfür die Technik des Schablonendrucks, insbesondere des Siebdrucks bevorzugt.

Bei Verwendung des Siebdrucks, kann durch die geeignete Wahl des Siebs ebenfalls, zusammen mit Einstellung der Rheologie der Glaslotpaste, Einfluß auf die Dicke der Glaslotschicht 5 genommen werden.

Erfindungsgemäß kann die Glaslotschicht 5 auf eine einstückige Mutterplatte 18 in vordefinierter Form aufgedruckt werden, kann durch Erwärmung eine Vorverglasung vorgenommen werden und kann danach entlang von Bruchkanten 25, 26 und 27, beispielsweise durch Ritzen und Brechen der Mutterplatte 18 eine Vereinzelung der Scheiben beziehungsweise der Fensterflächen 19 bis 24 durchgeführt werden.

An Stelle des Ritzens und Brechens können andere Schneid- oder Trennvorgänge, wie beispielsweise das Laser- oder das Ultraschalltrennen Verwendung finden.

Alternativ kann auch eine Vielzahl bereits vereinzelter Fensterflächen 19 bis 24 durch die Mutterplatte 18, welche dann als rechteckförmiger Rahmen ausgebildet ist, gehalten werden und kann diese Anordnung geeignet bedruckt und vorverglast werden.

Die Vorverglasung kann nach oder vor der Vereinzelung der jeweiligen Fensterflächen 19 bis 24 vorgenommen werden.

Ferner kann in weiterer erfindungsgemäßer Ausgestaltung, wie beispielsweise in Fig. 14 für die in Fig. 10 dargestellte Optokappe schematisch gezeigt ist, mittels nur eines einzigen Auftragvorgangs eine vollständig geschlossene Lotschnur 26 aufgetragen werden. Dies geschieht mit Hilfe eines Dispensers 27, der eine ringförmige Düse 28 aufweist und vorzugsweise eine Zeit/Drucksteuereinrichtung für den Auftragsvorgang umfasst.

Ferner kann die in Fig. 11 dargestellt Mutterplatte 18 auch mit einer entsprechend geformten rechteckförmigen Einfach- oder Mehrfach-Düse schrittweise bedruckt werden, wobei eine Steppervorrichtung jeweils einen Versatz vorzugsweise um die Breite oder Länge einer Fensterfläche der Fenster 19 bis 24 erzeugt.

Die vorstehend beschriebenen Verfahren ermöglichen es, selbst kleinste und komplizierte Glasgeometrien in der erforderlichen Genauigkeit mit einer Glaslotschicht zu versehen und sind somit auch für einen Einsatz bei der Gehäusung kleinster Baugruppen, ja sogar einzelner mikromechanischer Elemente, MEM's, geeignet.

## Patentansprüche

1. Verfahren zum Herstellen eines Gehäusekörpers, oder zumindest von Teilen eines Gehäusekörpers, insbesondere zum Herstellen einer Verkapselung von optoelektronischen Bauteilen, umfassend
das Zusammenfügen eines Gehäuseelements mit einer, vorzugsweise metallischen, Gehäuseanordnung,
das in Kontakt bringen von Gehäuseelement und Gehäuseanordnung mit einem Glaslot,
**dadurch gekennzeichnet,**
**dass** vor dem Zusammenfügen von Gehäuseelement und
Gehäuseanordnung das Glaslot als formbare Masse, insbesondere als Paste, aufgetragen wird,
**dass** durch zumindest einen einmaligen Energieeintrag, insbesondere durch Ausbrennen organischer Bestandteile, das Glaslot vorverglast und in seiner Form fixiert wird
und **dass** nach Einsetzen des Gehäuseelements in die Gehäuseanordnung durch Erwärmen eine zumindest bereichsweise hermetische Verbindung zwischen Gehäuseelement und Gehäuseanordnung hergestellt wird.

2. Verfahren nach Anspruch 1, **dadurch gekennzeichnet, dass** das Gehäuseelement ein Fenster, welches aus einer Glasscheibe besteht, und die Gehäuseanordnung eine Gehäusekappe umfasst.

3. Verfahren nach Anspruch 1 oder 2, **dadurch gekennzeichnet, dass** das Auftragen der Glaslotpaste zumindest bereichsweise auf der Glasscheibe und/oder der Gehäusekappe erfolgt.

4. Verfahren nach einem der Ansprüche 1, 2 oder 3, **dadurch gekennzeichnet, dass** das Auftragen der Glaslotpaste in die Gehäusekappe auf einer im Umfangsbereich angeordneten Auflagefläche erfolgt.

5. Verfahren nach einem der Ansprüche von 1 bis 4, **dadurch gekennzeichnet, dass** das Auftragen der Glaslotpaste auf die Auflagefläche in der Gehäusekappe in einem durch eine Sicke von der übrigen Auflagefläche abgegrenzten Lotbereich erfolgt.

6. Verfahren nach einem der Ansprüche von 1 bis 5, **dadurch gekennzeichnet, dass** das Auftragen der Glaslotpaste auf eine eckige, vorzugsweise eine rechteckige Glasscheibe oder Gehäusekappe erfolgt.

7. Verfahren nach einem der Ansprüche von 1 bis 6, **dadurch gekennzeichnet, dass** die Glaslotpaste auf eine Antireflex- oder Antikratzschicht aufgetragen wird, welche an der Oberfläche des Gehäuselements, insbesondere des Fensters angeordnet ist.

8. Verfahren nach einem der Ansprüche von 1 bis 7, **dadurch gekennzeichnet, dass** die Formgebung der Glaslotpaste, insbesondere der Querschnitt oder die Dicke einer aufgetragenen Strecke durch Einstellung der Pastenrheologie beeinflußt und/oder eingestellt wird.

9. Verfahren nach einem der Ansprüche von 1 bis 8, **dadurch gekennzeichnet, dass** die Glaslotpaste mittels einer Dosiervorrichtung, insbesondere mittels eines Dispensers und vorzugsweise mittels eines Nadeldispensers, dosiert aufgetragen wird.

10. Verfahren nach Anspruch 9, **dadurch gekennzeichnet, dass** die Dosiervorrichtung ein mit einer Düse versehener Ring- oder Rechteckdispenser ist.

11. Verfahren nach Anspruch 9 oder 10, **dadurch gekennzeichnet, dass** durch Wahl der Dispensernadel oder der Abmessungen der Düse die Lotschnurdicke des pastenförmig aufgebrachten Glaslots beinflusst und/oder eingestellt wird.

12. Verfahren nach Anspruch 9 bis 11, **dadurch gekennzeichnet, dass** das Glaslot durch eine Druck/Zeitsteuerung gesteuert aus der Nadel gepresst und/oder die Verfahrgeschwindigkeit der Dispensernadel zumindest während des Auftragens der Glaslotpaste eingestellt wird.

13. Verfahren nach einem der Ansprüche von 1 bis 7, **dadurch gekennzeichnet, dass** die Glaslotpaste mittels Siebdrucktechnik vorzugsweise auf die Glasscheibe aufgetragen wird.

14. Verfahren nach Anspruch 13, **dadurch gekennzeichnet, dass** die Formgebung der Glaslotpaste, insbesondere die Dicke der Lotschnur durch mehrfachen Auftrag beeinflußt und/oder eingestellt wird.

15. Verfahren nach Anspruch 13 und 14, **dadurch gekennzeichnet, dass** die Formgebung der Glaslotpaste durch die Geometrie des Siebes und oder einer Druckschablone beeinflusst und/oder eingestellt wird.

16. Verfahren nach einem der Ansprüche von 13 bis 15, **dadurch gekennzeichnet, dass** zunächst auf einer Mutterscheibe, welche eine Vielzahl von Einzelscheiben definiert oder umfasst, ein Glaslot in vordefinierter Flächengeometrie aufgebracht wird,
durch einen Energieeintrag, insbesondere durch Ausbrennen organischer Bestandteile das Glaslot vorverglast und in seiner Form fixiert wird,
Scheiben aus der Mutterscheibe vereinzelt werden und
die vereinzelte Scheibe mit vorverglastem Glaslot in die Gehäusekappe eingesetzt und
durch thermische Einwirkung eine hermetische Verbindung zwischen Glasscheibe und Gehäusekappe hergestellt wird.

17. Verfahren nach einem der Ansprüche von 12 bis 16, **dadurch gekennzeichnet, dass** die Scheibe aus der Mutterglasscheibe durch Ritzen und Brechen oder mittels Laserschneiden vereinzelt wird.

18. Verfahren nach einem der Ansprüche von 1 bis 17, **dadurch gekennzeichnet, dass** ein Sinterglas-Formkörper und pasteuses Glaslot auf den Gehäusekörper und/oder das Gehäuseelement aufgebracht wird.

19. Gehäusekörper, **dadurch gekennzeichnet, daß** dieser mit einem Verfahren gemäß einem der Ansprüche von 1 bis 18 hergestellt ist.

20. Gehäusekörper nach Anspruch 19, **dadurch gekennzeichnet, daß** dieser einen Abschnitt eines vorverglasten Glaslots umfasst.

21. Gehäusekörper nach Anspruch 19 oder 20 umfassend eine metallische, hülsenförmigen Kappe, ein Gehäuseelement, welches vorzugsweise eine als Fenster dienende Glasscheibe aufweist, sowie ein zwischen Fenster und Metallkappe angeordnetes Glaslot.

22. Gehäusekörper nach Anspruch 21, **dadurch gekennzeichnet, dass** der Gehäusekörper eine Optokappe zur Verkapselung von optischen Bauelementen wie Laser oder Photodioden umfasst.

23. Gehäusekörper nach Anspruch 22, umfassend eine runde oder rechteckige Metallhülse und eine zu einer inneren Stirnfläche der Metallhülse im wesentlichen kongruenten runde oder rechteckige Glasscheibe, welche stirnseitig die Metallhülse von deren Innenseite her berührt und ein auf Glasscheibe und / oder Metallhülse aufgetragenes Glaslot, welches mittels Dispensen oder Siebdruck aufgetragen ist.

24. Gehäusekörper nach Anspruch 23, **dadurch gekennzeichnet, dass** die Metallhülse im Innern eine stirnseitig umlaufende Auflage besitzt, auf der die Glaslotpaste angeordnet ist.

25. Gehäusekörper nach Anspruch 24, **dadurch gekennzeichnet, dass** die stirnseitig umlaufende Auflage eine Sicke besitzt, die einen für das Glaslot vorgesehenen Lotbereich von der übrigen Fläche der Auflage abgrenzt.

26. Gehäusekörper nach einem der Ansprüche von 19 bis 25, **dadurch gekennzeichnet, dass** die Ebene der umlaufenden Auflage relativ zu einer Längsachse des Gehäusekörpers geneigt ist.

27. Gehäusekörper nach einem der Ansprüche von 19 bis 26, **dadurch gekennzeichnet, dass** die Glasscheibe mit einer Antireflex- und/oder Antikratzschicht versehen ist und auf die geneigte Auflage aufgelötet ist.

28. Gehäusekörper nach Anspruch 21, **dadurch gekennzeichnet, dass** das Gehäuseelement ein optisches Element umfasst, welches eine Linse, Zylinderlinse oder sphärische Linse ist.

## Claims

1. Method for producing a housing body or at least parts of a housing body, in particular for producing an encapsulation of opto-electronic components, comprising the fitting together of a housing element with a housing arrangement which is preferably metallic,
the bringing into contact of the housing element and the housing arrangement with a glass solder,
**characterised in that**
before the housing element and the housing arrangement are fitted together the glass solder is applied as a mouldable mass, in particular as a paste,
**in that** the glass solder is pre-vitrified and fixed in its shape through at least a single energy input, in particular through the burning of organic components
and **in that** after the insertion of the housing element into the housing arrangement an at least area-wise hermetic connection is produced between the housing element and the housing arrangement through heating.

2. Method according to claim 1, **characterised in that** the housing element comprises a window which consists of a pane of glass and the housing arrangement comprises a housing cap.

3. Method according to claim 1 or 2, **characterised in that** the application of the glass solder paste takes place at least area-wise on the pane of glass and / or the housing cap.

4. Method according to one of the claims 1, 2 or 3, **characterised in that** the application of the glass solder paste in the housing cap takes place on a supporting surface arranged in the peripheral region.

5. Method according to one of the claims 1 to 4, **characterised in that** the application of the glass solder paste to the supporting surface in the housing cap is carried out in a solder region delimited by a bead from the remaining supporting surface.

6. Method according to one of the claims 1 to 5, **characterised in that** the application of the glass solder paste takes place on a cornered, preferably a four-cornered, pane of glass or housing cap.

7. Method according to one of the claims 1 to 6, **characterised in that** the glass solder paste is applied to an anti-reflect / or anti-scratch layer which is arranged on the surface of the housing element, in particular the window.

8. Method according to one of the claims 1 to 7, **characterised in that** the moulding of the glass solder paste, in particular the cross-section or the thickness of an applied stretch, is set and / or influenced through setting of the paste rheology.

9. Method according to one of the claims 1 to 8, **characterised in that** the glass solder paste is applied in a dosed manner by means of a dosage device, in particular by means of a dispenser and preferably by means of a needle dispenser.

10. Method according to claim 9, **characterised in that** the dosage device is an annular or rectangular dispenser provided with a nozzle.

11. Method according to claim 9 or 10, **characterised in that** the thickness of the solder line of the glass solder applied in the form of a paste can be influenced and / or set through the selection of the dispenser needle or the dimensions of the nozzle.

12. Method according to claim 9 to 11, **characterised in that** the glass solder is pressed out of the needle with control through a pressure / time control unit and / or the speed of movement of the dispenser needle is set at least during the application of the glass solder paste.

13. Method according to one of the claims 1 to 7, **characterised in that** the glass solder paste is applied to the pane of glass preferably by means of screen printing technology.

14. Method according to claim 13, **characterised in that** the moulding of the glass solder paste, in particular the thickness of the solder line, is influenced and / or set through multiple applications.

15. Method according to claim 13 and 14, **characterised in that** the moulding of the glass solder paste is influenced and / or set by the geometry of the screening equipment and or a pressure template.

16. Method according to one of the claims 13 to 15, **characterised in that** firstly a glass solder is applied with predefined area geometry to a master pane of glass which defines or comprises a plurality of individual panes,
the glass solder is pre-vitrified and fixed in its shape through an energy input, in particular through burning organic components,
panes are isolated from the mother pane and
the isolated pane with pre-vitrified glass solder is inserted into the housing cap
and a hermetic connection is produced between the pane of glass and the housing cap through thermal effects.

17. Method according to one of the claims 12 to 16, **characterised in that** the pane is isolated from the mother pane of glass through scratching and breaking or by means of laser cutting.

18. Method according to one of the claims 1 to 17, **characterised in that** a sintered glass mould and paste-like glass solder are applied to the housing body and /or the housing element.

19. A housing body, **characterised in that** it is produced with a method according to one of the claims 1 to 18.

20. A housing body according to claim 19, **characterised in that** it comprises a section of a pre-vitrified glass solder.

21. A housing body according to claim 19 or 20, comprising a metallic, sleeve-type cap, a housing element which preferably comprises a pane of glass serving as a window and a glass solder arranged between the window and the metal cap.

22. A housing body according to claim 21, **characterised in that** the housing body comprises an optical cap for the encapsulation of optical components like lasers or photodiodes.

23. Housing body according to claim 22, comprising a round or rectangular metal sleeve and a round or rectangular pane of glass which is essentially congruent with an inner end area of the metal sleeve, said pane of glass contacting the metal sleeve from the inner side of same, and a glass solder applied to a pane of glass and / or metal sleeve which is applied by means of dispensing or screen printing.

24. A housing body according to claim 23, **characterised in that** the metal sleeve has a supporting surface running inside on the end face, on which the glass solder paste is arranged.

25. A housing body according to claim 24, **characterised in that** the supporting surface running around the end face comprises a bead which delimits a solder region provided for the glass solder from the remaining area of the supporting surface.

26. A housing body according to one of the claims 19 to 25, **characterised in that** the plane of the supporting area, running around, is inclined relatively to a longitudinal axis of the housing body.

27. A housing body according to one of the claims 19 to 26, **characterised in that** the pane of glass is provided with an anti-reflect and / or anti-scratch layer and is soldered onto the inclined supporting surface.

28. A housing body according to claim 21, **characterised**
**in that** the housing element comprises an optical element which is a lens, cylindrical lens or spherical lens.

## Revendications

1. Procédé destiné à la fabrication d'un corps de boîtier ou du moins de parties d'un corps de boîtier, notamment à la fabrication d'un encapsulage de composants optoélectroniques, comportant
l'assemblage d'un élément de boîtier avec un agencement de boîtier de préférence métallique,
la mise en contact de l'élément de boîtier et de l'agencement de boîtier avec une brasure de verre,
**caractérisé en ce que**,
avant l'assemblage de l'élément de boîtier et l'agencement de boîtier, la brasure de verre est appliquée à l'état de masse pouvant être conformée, notamment à l'état de pâte,
**en ce que** par au moins un unique apport d'énergie, notamment par combustion de composés organiques, la brasure de verre est préalablement vitrifiée et fixée dans sa forme,
et **en ce que**, après l'insertion de l'élément de boîtier dans l'agencement de boîtier, une liaison hermétique est établie par chauffage entre l'élément de boîtier et l'agencement de boîtier, au moins par zones.

2. Procédé selon la revendication 1, **caractérisé en ce que** l'élément de boîtier comporte une fenêtre qui est constituée d'une plaque de verre, et **en ce que** l'agencement de boîtier comporte un couvercle de boîtier.

3. Procédé selon la revendication 1 ou 2, **caractérisé en ce que** l'application de la pâte de brasure de verre est effectuée, au moins par zones, sur la plaque de verre et/ou sur le couvercle de boîtier.

4. Procédé selon l'une des revendications 1, 2 ou 3, **caractérisé en ce que** l'application de la pâte de brasure de verre est effectuée dans le couvercle de boîtier sur une surface d'appui disposée dans la zone périphérique.

5. Procédé selon l'une des revendications 1 à 4, **caractérisé en ce que** l'application de la pâte de brasure de verre sur la surface d'appui prévue dans le couvercle de boîtier est effectuée dans une zone de brasage, qui est délimitée du reste de la surface d'appui par une moulure.

6. Procédé selon l'une des revendications 1 à 5, **caractérisé en ce que** l'application de la pâte de brasure de verre est effectuée sur une plaque de verre ou sur un couvercle de boîtier angulaire, de préférence rectangulaire.

7. Procédé selon l'une des revendications 1 à 6, **caractérisé en ce que** la pâte de brasure de verre est appliquée sur une couche antireflets ou antirayures, qui est disposée sur la surface de l'élément de boîtier, notamment de la fenêtre.

8. Procédé selon l'une des revendications 1 à 7, **caractérisé en ce que** la conformation de la pâte de brasure de verre, notamment la section transversale ou l'épaisseur d'un tronçon appliqué, est influencée et/ou réglée par le réglage de la rhéologie de la pâte.

9. Procédé selon l'une des revendications 1 à 8, **caractérisé en ce que** la pâte de brasure de verre est appliquée de façon dosée au moyen d'un dispositif de dosage, notamment au moyen d'un dispensateur, et de préférence au moyen d'un dispensateur à aiguille.

10. Procédé selon la revendication 9, **caractérisé en ce que** le dispositif de dosage est un dispensateur annulaire ou rectangulaire doté d'une buse.

11. Procédé selon la revendication 9 ou 10, **caractérisé en ce que** l'épaisseur du cordon de la brasure de verre appliquée à l'état de pâte peut être influencée et/ou réglée par le choix de l'aiguille du dispensateur ou des dimensions de la buse.

12. Procédé selon l'une des revendications 9 à 11, **caractérisé en ce que** la brasure de verre est exprimée de l'aiguille en étant commandée par une commande de pression / temps, et/ou **en ce que** la vitesse de déplacement de l'aiguille du dispensateur est régulée, au moins pendant l'application de la pâte de brasure de verre.

13. Procédé selon l'une des revendications 1 à 7, **caractérisé en ce que** la pâte de brasure de verre est de préférence appliquée sur la plaque de verre par technique de sérigraphie.

14. Procédé selon la revendication 13, **caractérisé en ce que** la conformation de la pâte de brasure de verre, notamment l'épaisseur du cordon de brasure, est influencée et/ou réglée par une application réitérée.

15. Procédé selon la revendication 13 ou 14, **caractérisé en ce que** la conformation de la pâte de brasure de verre est influencée et/ou réglée par la géométrie du tamis et/ou d'un pochoir.

16. Procédé selon l'une des revendications 13 à 15, **caractérisé en ce qu'**une brasure de verre à géométrie de surface prédéfinie est appliquée dans un premier temps sur une plaque mère, qui définit ou comporte une pluralité de plaques individuelles,
**en ce que** la brasure de verre est préalablement vitrifiée par un apport d'énergie, notamment par combustion de composés organiques, et fixée dans sa forme,
**en ce que** des plaques sont individualisées à partir de la plaque mère, et
**en ce que** la plaque individualisée avec la brasure de verre préalablement vitrifiée est insérée dans le couvercle de boîtier, et
**en ce qu'**une liaison hermétique est établie par effet thermique entre la plaque de verre et le couvercle de boîtier.

17. Procédé selon l'une des revendications 12 à 16, **caractérisé en ce que** la plaque est individualisée de la plaque de verre mère par entaille et rupture ou au moyen d'une découpe au laser.

18. Procédé selon l'une des revendications 1 à 17, **caractérisé en ce qu'**un corps moulé en verre fritté et de la brasure pâteuse de verre sont appliqués sur le corps de boîtier et/ou sur l'élément de boîtier.

19. Corps de boîtier, **caractérisé en ce qu'**il est fabriqué avec un procédé selon l'une des revendications 1 à 18.

20. Corps de boîtier selon la revendication 19, **caractérisé en ce qu'**il comporte un tronçon d'une brasure de verre préalablement vitrifiée.

21. Corps de boîtier selon la revendication 19 ou 20, comportant un couvercle métallique en forme de douille, un élément de boîtier qui est de préférence muni d'une plaque de verre servant de fenêtre, ainsi qu'une brasure de verre disposée entre la fenêtre et le couvercle métallique.

22. Corps de boîtier selon la revendication 21, **caractérisé en ce que** le corps de boîtier comporte un couvercle d'optique pour l'encapsulage de composants optiques, tels que des lasers ou des photodiodes.

23. Corps de boîtier selon la revendication 22, comportant une douille métallique ronde ou rectangulaire et, sensiblement congruente à une face frontale intérieure de la douille métallique, une plaque de verre ronde ou rectangulaire qui est en contact avec la face frontale de la douille métallique à partir de la face intérieure de celle-ci, et
une brasure de verre appliquée sur la plaque de verre et/ou sur la douille métallique, qui est appliquée au moyen de dispensateurs ou de sérigraphie.

24. Corps de boîtier selon la revendication 23, **caractérisé en ce que** la douille métallique possède en face frontale une surface d'appui intérieure périphérique, sur laquelle est disposée la pâte de brasure de verre.

25. Corps de boîtier selon la revendication 24, **caractérisé en ce que** la surface d'appui périphérique frontale comporte une moulure, qui délimite une zone de brasage prévue pour la brasure de verre par rapport au reste de la surface d'appui.

26. Corps de boîtier selon l'une des revendications 19 à 25, **caractérisé en ce que** le plan de la surface d'appui périphérique est incliné par rapport à un axe longitudinal du corps de boîtier.

27. Corps de boîtier selon l'une des revendications 19 à 26, **caractérisé en ce que** la plaque de verre est dotée d'une couche antireflets et/ou antirayures, et est brasée sur la surface d'appui inclinée.

28. Corps de boîtier selon la revendication 21, **caractérisé en ce que** l'élément de boîtier comporte un élément optique qui est une lentille, une lentille cylindrique ou une lentille sphérique.
